# EUROPEAN PATENT SPECIFICATION

(11) **EP 3 712 568 B1**
(45) Date of publication and mention of the grant of the patent: **24.08.2022**
(21) Application number: 20164250.1
(22) Date of filing: 19.03.2020
(51) Int. Cl.: G01D 11/24, G01P 1/02, G06K 19/077, H05K 5/00

(54) **METHODS FOR MANUFACTURING A CASE, COMPONENTS OF A CASE AND A DEVICE, A MANUFACTURING SET AND A DEVICE**
VERFAHREN ZUR HERSTELLUNG EINES GEHÄUSES, KOMPONENTEN EINES GEHÄUSES UND VORRICHTUNG, HERSTELLUNGSSATZ UND VORRICHTUNG
PROCÉDÉS DE FABRICATION D'UN BOÎTIER, COMPOSANTS D'UN BOÎTIER ET D'UN DISPOSITIF, ENSEMBLE DE FABRICATION ET DISPOSITIF

(30) Priority: 19.03.2019 FI 20197051
(43) Date of publication of application: 23.09.2020
(73) Proprietor: doop Osakeyhtiö, 20100 Turku (FI)
(72) Inventor: Lehtonen, Antero, 20210 Turku (FI)

(56) References cited:
- US-A1- 2010 310 829
- US-A1- 2015 036 845
- US-B1- 6 428 650

## Description

### TECHNICAL FIELD OF THE INVENTION

The invention relates to methods of manufacturing a case and its components as well as manufacturing of a device in accordance with the independent claims presented below. The invention also relates to a manufacturing set for the case and a device.

### TECHNICAL BACKGROUND

Cases are manufactured using different methods. However, they can be improved. Patent publication US 2002/0001181 A1 presents a casing meant for memory cards. TW201208918 A1 presents a casing for an RFID tag and an antenna that is embedded in a license plate. US 2015/036845 A1 discloses a cover for an electronic device.

### OBJECT OF THE INVENTION

The object of the present invention is to reduce or even eliminate problems occurring in the prior art.

The object of the present invention is to create a case, built of separate components, that is durable, waterproof, dust-proof, hard to open without permission, and without visible fasteners. The object is to accomplish an affordable case that can be easily manufactured even in small series. The object is also to generate a case that can be sent to the place of use in parts and that can be assembled as needed. One object is to generate a case that can be opened and reused. One object is to achieve a new type of case solution that is suitable for manufacturing both small and big cases. One object is to achieve a solution that allows for cases of different sizes and/or shapes to be manufactured easily using the same components. One object is to achieve a solution where the size and/or shape of the case can be chosen during assembly.

One object is to achieve a new type of a case for a device, especially for a device with electrical components. One object is to generate an electrical device that has a better case than any existing one.

### SHORT DESCRIPTION OF THE INVENTION

Among other things, to achieve the objects mentioned above, the invention is characterized by what is presented in the attached independent patent claims.

Where applicable, the embodiments and benefits mentioned in this text pertain to methods, manufacturing sets, and devices according to the invention as well as other objects of the invention even though it might not always be specifically mentioned.

In this text, a case is considered to mean all kinds of items meant for storage and/or protection comprising a storage space. Other suitable terms for "case" could also be "container," "casing" and "housing." In this English translation, these terms can be used to mean the various manifestations and embodiments of the same idea of the invention.

In a typical method for manufacturing components of a case according to the invention, sheet-like material is processed. In this case, sheet-like refers to material that is relatively thin in one direction, i.e. in direction of its thickness, in comparison to its other directions, i.e. in direction of its plane. The sheet-like material comprises two surfaces arranged in the direction of its plane. The surfaces may be straight and parallel with each other, whereby the sheet-like material is planar and of an even thickness. The invention may also be used with uneven and non-planar sheet-like materials. The method comprises, at least, the following steps:
- coating at least part of a sheet-like material on at least one of its surfaces with an adhesive, such as glue or double-sided tape, that is compatible with materials used;
- working sheet-like material into at least two sheet-like components with two surfaces and edges, of which components at least one is worked out of the sheet-like material coated with an adhesive, whereby, while working the material, also removing adhesive the material is coated with, for example by cutting the tape that has been used to coat the component;
- working a storage space into at least one of the components.

In order to form a case with a storage space in it, the components are attachable to one another on their surfaces with help of said adhesive.

Using the method according to the invention it is possible to manufacture a manufacturing set for a case according to the invention. It comprises at least two sheet-like components that have two surfaces and edges. A storage space is worked in at least one of the components. At least one of the components has been worked out of sheet-like material coated with an adhesive in such a way that said component is coated with the adhesive on at least one of its surfaces. In this way, the components are attachable to one another on their surfaces with help of said adhesive, such as double-sided tape, so that said storage space is formed inside the case.

The storage space of the invention can be for example just a recess, or an opening through a component or a combination of these two. The same component may comprise multiple storage spaces.

In an embodiment of the invention, the case and its manufacturing set comprise at least three components attachable on top of each other. For example, the case can consist of two components meant to form the ends and a component comprising a storage space to be attached between them.

Typically, in a method for manufacturing a case according to the invention, components that have been manufactured according to the invention will be used. In the method, at least two sheet-like components are attached to one another by their surfaces. At least one component is coated with an adhesive, such as double-sided tape, and at least one component has a storage space worked into it. The components are attached to one another using said adhesive, so that a case with said storage space in it is formed. Thus, by using the invention, one can manufacture a case, which is formed in the manner described above, by using two or more sheet-like components that are attached to one another with an adhesive.

So, it has now been noticed that a case, for example a case of an electrical device can be easily and quickly manufactured by working components out of sheet-like material and gluing them together on top of each other. This way a case thicker than the original sheet-like material is formed. The more components that are glued on top of one another, the higher the case that can be obtained. According to the invention, the gluing is carried out with an adhesive, e.g. double-sided tape, applied to a surface of the sheet-like material. The adhesive is applied, that is, for example the tape is attached, to at least a portion of the sheet-like material before working it into components. Thereby, when cutting and working the components, the adhesive is also removed, e.g. by also cutting the tape with which the component is coated. In other words, the adhesive used to attach the components together is formed automatically onto the component as it is being worked. The adhesive, such as tape, automatically conforms to the shape of the component, so that it is not necessary to form or finish it by hand.

In an embodiment, while working the sheet-like material, sheet-like material is removed. In an embodiment, both the sheet-like material as well as adhesive on the surface of the sheet-like material are cut off from next to a component, while working the sheet-like material. In an embodiment, while working a storage space into at least one component, both adhesive and sheet-like material are removed.

Various adhesives, such as tapes, are known in the prior art. The adhesive can be any substance suitable for gluing of materials used in the invention, for example, glue applicable as a liquid or double-sided tape. For example, common sheet material or straight strip-like material can be used as tape, and a particularly shaped specially produced tape is not needed.

One advantage of the invention is that the same components can easily be used to manufacture cases of various shapes and sizes. The size and/or shape of the case can be decided as late as at the time of assembly.

In an embodiment, in order to make the handling of the sheet-like material easier, the adhesive comprises a protective covering or it is covered with one, such as a paper, plastic or similar. The protective covering is placed on top of a glue applied as a liquid usually once the adhesive has been applied to the surface of the sheet-like material. One of the advantages of double-sided tape is that the surface of the tape, which is not attached to a component, is pre-covered with a protective cover, such as paper, plastic or similar. The protective covering is typically kept on the adhesive until one starts to attach the components to one another. In other words, the protective covering is usually removed before attaching the components to one another. In this way, unattached components, coated with an adhesive or adhesive sticker, do not accidentally stick to anything. These components and manufacturing sets for a case according to the invention can be transported in parts to their final place of use, to a client or store, for example. At a desired moment, the final user may remove the protective covering from adhesives and assemble the case or device without any need for special tools.

The adhesive, such as double-sided tape, is easy and quick to use as an attachment means. The adhesive, such as tape, improves the look of the finished product since no staples, screws or other mechanical attachment means are needed. The adhesive used in e.g. the tape may be e.g. acrylic glue. In an embodiment the adhesive is elastic. It is often beneficial if the adhesive does not dry easily. Adhesives, such as double-sided tape, and their usage are common knowledge as such, and their properties will not be discussed further in this document.

The sheet-like material can be, for example, plastic, wood or metal. Examples of suitable materials are PMMA (polymethyl methacrylate, acrylic), PC (polycarbonate), foamcore, plywood, laminated timber, steel, aluminium.

In an embodiment of the invention, components are worked out of sheet-like material with one of the following methods: laser cutting, water jet cutting, NC machining or by material-removing machining. These and other machining methods are common knowledge and will not be discussed further in this document.

In an embodiment of the invention, into one or more components meant to be middle components of a case, a storage space has been worked by removing material from the entire depth of the component. In an embodiment, material is removed from the central part of at least one component while leaving the edges of the component, which are meant to form a part of the case. The edges may circle the entire component, whereby a storage space is left in the centre. The edges can also be left open at some part, the edges thus forming a U-shape, for example, thereby creating an opening that connects the exterior of the case and the storage space at the location of the open part of the component.

In an embodiment, material is removed from the entire depth of only a small part of one or more components. Simultaneously, if wanted, the storage space can be made bigger without piercing the depth of the entire component throughout the whole area of the storage space. In this manner, the components can form e.g. a case, which has one or two smaller openings on its surfaces and yet a relatively large storage space inside the case.

In an embodiment of the invention, a storage space is worked into at least one of the components by forming a recess on the surface of the component, which recess does not pierce the sheet-like component. This type of component, not comprising openings, can be used e.g. as the outermost piece, in other words, the end component of the case.

In an embodiment, a component without openings and without a storage space is used as the end component of the case. A component that has been worked as little as possible or not at all, or a simple component, is inexpensive to manufacture and easy to handle.

A surface of an end component can be coated with an adhesive either partly or completely. In a finished case, a part of an inner surface of the end component can be a part of an inner wall of a storage space. If this type of inner wall of a storage space is coated with an adhesive then it is easy to firmly attach parts that will be arranged inside of the case, such as an electrical component, to this inner wall.

In an embodiment of the invention, the case has end components and two or more middle components between them. In an embodiment, the middle components are generally of the same shape and are aligned with one another when attached. If all these middle components comprise a storage part that pierces the entire component, then a storage part with the depth of multiple components is formed between the ends. In this manner, even a large item can be stored in the case. In an embodiment, the storage parts piercing the middle components are of same shape. In this manner a storage space with e.g. straight walls can easily be formed inside the case.

Some of the components may be coated with an adhesive, such as tape, some may be left without an adhesive. Typically, an adhesive is only needed on one of the surfaces to be attached face to face. For example, if the case is formed of two components meant to be the end components, and a component comprising a storage space to be attached between them, then two surfaces coated with an adhesive are necessary. In this case, the adhesive, such as tape, may be a) on the surfaces meant towards the storage space on both end components, b) on both surfaces of the storage space component, c) on one end component and on a surface of the storage space component meant towards the other end.

The components to be attached to one another may be of different shapes or sizes. In this case, the adhesive can be on the smaller component.

The surface of the component may be only partly coated with an adhesive. The quantity and location of the adhesive can be used to determine the strength of the attachment. In this manner, e.g. a once closed case can be arranged re-openable and possibly even to be used again. Of the surfaces of the two components to be attached aligned together for example 100 %, under 100 %, under 90 %, under 80 %, under 70 %, under 60 %, under 50 %, under 40 %, under 30 %, under 20 %, under 10 %, 5-90 %, 10-80 %, 25-75 %, 30-60 % can be coated with an adhesive.

In a typical method for manufacturing a device according to the invention, at least one electrical component is placed in the storage space of a case that is manufactured according to the invention. Therefore, the device according to the invention comprises a case that is assembled from a manufacturing set according to the invention, and at least one electrical component placed in the storage space of the case.

In an embodiment of the invention, the components of the case are attached to one another with an adhesive, such as tape, in a watertight manner, so that the aforementioned at least one electrical component will be protected from water and/or dust and/or gasses. With an adhesive according to the invention, such as double-sided tape, the case can easily be made watertight and/or dust-tight or even gastight.

In an embodiment, one or more electrical components are attached firmly to the case by arranging adhesive, such as double-sided tape on one of the inner walls of the storage space, on which adhesive the electrical component is attached. Therefore, the case is suitable as a case for electrical devices in different conditions.

In an embodiment of the invention, the device comprises an accelerometer, radio transmitter and micro controller that are functionally connected with each other and placed in the storage space. This type of device may function as a sensor for multiple purposes, for example, as a motion sensor or a position sensor. One possible application is monitoring a patient or some other person. One possible application is the monitoring of an item such as a device or a piece of furniture, the item may be e.g. a patient care device or piece of furniture of a care facility or hospital. When attached to a patient or other person or item, the device can send, to a receiver, information on the position and movement of the patient or the item. By comparing this information to reference values, deductions can be made on e.g. location, movement, health and vitality level of the patient. Deductions can be made on the location, movement and function of the monitored item. For example, on basis of the acceleration and position data produced by a motion or position sensor, one can find out whether a patient or device is being handled appropriately. Through comparison, one can take action, if necessary, such as sounding an alarm or contacting the nursing staff, the patient's family or the monitored person herself such as the patient, or the owner of the monitored item or maintenance staff.

The storage space of the case can be fitted with, for example, an RFID device (Radio Frequency IDentification), an NFC device (Near Field Communication), a LED (Light Emitting Diode), an electrical display device, a speaker or other sound device, accumulator or a battery.

In an embodiment of the invention, the case is partly, e.g. from one of its ends, translucent or transparent. In this case e.g. light produced by a LED or an electrical display can be seen through the case, i.e. the device can communicate its status visually.

In an embodiment of the invention, in at least two components, or advantageously in all of the components of the case, alignment openings have been formed for proper alignment of the components. In a finished case, the alignment openings are set to align with each other. The same or similar openings can also act as an attachment mechanism for the case or device. Through the openings, one can arrange e.g. a cable tie, a cable, a screw, a nail or other attachment means with which the case can be attached to a desired location.

The case achieved with the invention suits excellently for the storage of relatively small objects. For example, it can form a medicine container, whose inconspicuous or unauthorized opening, or in other words tampering, is not possible. The invention is also suitable for the manufacturing of large cases.

Various, different sheet-like materials and adhesives, such as tapes, can be used in the manufacturing of one case. For example, the end components of the case can be made from a different material or in a different colour than the components meant as middle components. The attachment of different materials may require the use of different adhesives, such as tapes, in different parts of the case.

### SHORT DESCRIPTION OF THE FIGURES

The invention is explained more precisely in the following by referring to the attached schematic drawing, where
- Figure 1: depicts a sheet-like material according to the invention and double-sided tape.
- Figure 2: depicts the sheet-like material in Figure 1 when it is coated with double-sided tape and has several components worked into it,
- Figure 3a: depicts a case according to the invention, in parts,
- Figure 3b: depicts the case in Figure 3a when assembled,
- Figure 4a: depicts a second case according to the invention,
- Figure 4b: depicts the case in Figure 4a partly assembled and fitted with electronics,
- Figure 4c: depicts a device according to the invention, i.e., the case in Figure 4b assembled.

### DETAILED DESCRIPTION OF THE EXAMPLES IN THE FIGURES

For clarity, same reference numbers are used for some corresponding parts in different figures and embodiments.

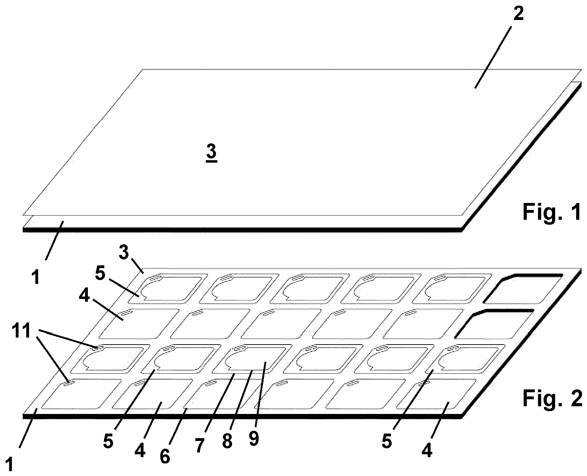

Figure 1 depicts a sheet-like material or e.g. sheet 1 of acrylic and double-sided tape 2. In the example, the sheet 1 and tape 2 are depicted as rectangular sheets of the same size. The invention can also be realized using materials and tapes that are of a different size and shape compared to one another. The sheet-like material 1 or double-sided tape 2 or both can be strip-like, i.e. in one direction very long or even "endless" strip. Double-sided tape is not the only adhesive that can be used, e.g. it is also possible to use an adhesive applicable as a liquid on the surface of the sheet-like material.

In the situation of Figure 1, a protective paper has been removed from the surface of the tape facing the sheet, which in the figure is the lower surface. In the figure, the protective paper 3 has been left on the upper surface of the tape to prevent the tape from attaching accidentally. The figures do not show how tape 2 is attached to the upper surface of sheet 1, but in this way, a tape-coated sheet is formed. Figure 2 shows sheet 1 coated with tape 2, which sheet has several sheet-like components 4, 5 worked into it e.g. with laser cutting. Two rows of six end components 4 and two rows of six middle components 5 comprising a storage space and intended to be placed in between the end components, have been worked into the sheet. In Figure 2, two components, which were formed by working the sheet, have been removed from the upper right-hand corner of sheet 1.

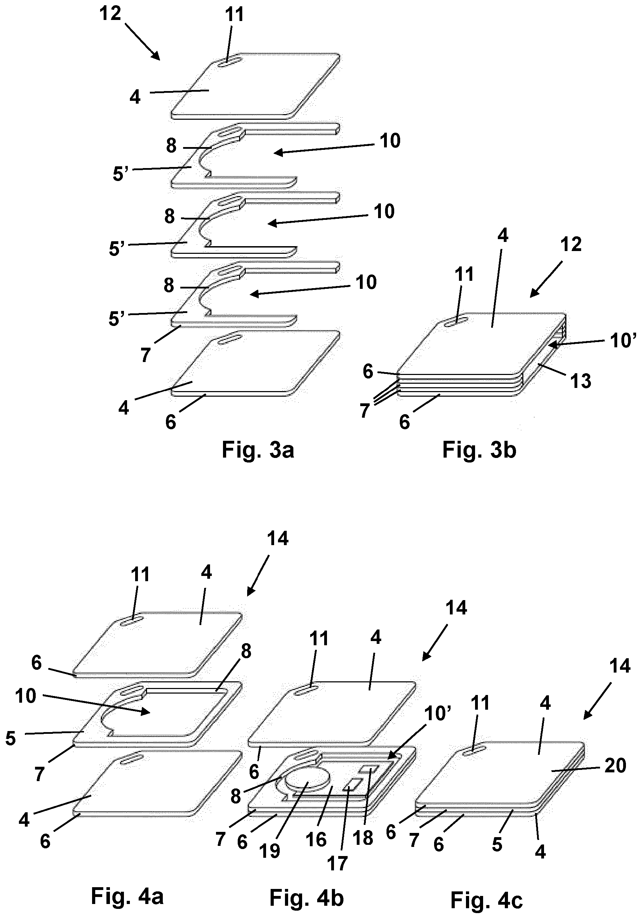

Into each end component 4 an outer edge 6 has been formed with a single edge cut. Thus, end component 4 does not have any openings in its central part, see, for example, Figure 4a. Middle components 5 have been cut on their outer edge 7 to the same shape as the outer edges of end components 6. However, the middle components have had a second cut cut into the inside of the outer edge, the second cut forming an inner edge 8 to the middle components. When the remaining sheet part 9 is removed from the inside of the inner edge 8, a storage space 10 is formed in its stead, see, for example, Figure 4a.

In one of the outer corners of both end components 4 and middle components 5, in between the middle components' outer edge 7 and inner edge 8, alignment and attachment openings 11 have been formed. The assembler of the device or case can easily assemble the case correctly by aligning these openings with each other. Openings 11 form an opening piercing the corner of the finished device or case, thereby allowing the device or case to be easily attached to a desired location.

In Figure 3a, a case 12 according to the invention is depicted in parts and in Figure 3b the same case 12 is shown assembled. Case 12 comprises two end components 4 of the same shape and three middle components 5' of the same shape. Together, the storage spaces 10 of the middle components form storage space 10' in the finished case, which storage space 10' is three times the height of one component 5'. The storage spaces 10 of the middle components 5' are formed to be open from their edge in one direction. In the finished case 12, these open parts form an opening 13 with a height of three components between the storage space 10' of the case and the exterior of the case. The opening 13 can be adjusted suitable to accommodate credit cards or business cards, for example.

Figure 4a depicts a case according to the invention in parts. Case 14 comprises two end components 4 of the same shape and of one middle component 5. The storage space 10 of the middle component forms in the finished case 14 a storage space 10' with the height of one component 5. Storage space 10 is closed on its edges in every direction. In the situation of Figure 4b, electrical components have been placed in storage space 10, i.e. a circuit board 16 which has a microcontroller 17, an accelerometer 18 and an accumulator or battery 19 and a radio transmitter (not shown in the figure) attached onto it. As one can see in the figure, the inner edge 8 of storage space 10 is formed to be fitted with the circuit board. In Figure 4c, case 14, i.e. an electrical device 20, is shown assembled. Because case 14 comprises end components 4 without openings and a middle component 5 with its edge 5 closed in every direction, the case can be closed with double-sided tape, or other adhesive, very tightly.

The parts in Figures 3a and 4a are examples of parts for a manufacturing set for a case according to the invention. If, in addition to the parts in Figure 4a, the necessary electrical components, such as parts 16, 17, 18 and 19 in Figure 4b are present, then this is an example of a manufacturing set for an electrical device 20.

In the examples of Figures 3a, 3b, 4a, 4c, an adhesive or double-sided tape is not separately shown. Components, which are to be attached together should have an adhesive, such as tape, between them on at least one of the surfaces to be attached together. An adhesive is not necessarily needed on the surfaces of the end components that are meant to be facing outwards. An adhesive, such as double-sided tape, could be used on a case surface meant to be facing outwards to attach the case or device to its desired location. For example, a device according to the invention equipped with a position sensor or a motion sensor could be attached to an object to be monitored, such as an item. In the examples of Figures 4a, 4b and 4c, it might be beneficial to furnish the inner surface of the lowest end component with tape or some other adhesive. In this manner, circuit board 16 placed against it would attach firmly.

The invention is not intended to be restricted to the presented examples, rather, the scope of protection is determined by the independent claims. Dependent claims present some advantageous embodiments of the invention.

## Claims

1. Method for manufacturing components of a case (12, 14), said case comprising at least two components made of sheet-like material, the components jointly forming a storage space, the method comprising at least following steps:
- first, coating at least part of a sheet-like material (1) on at least one of its surfaces with an adhesive (2);
- then, working said sheet-like material (1) into at least two sheet-like components (4, 5, 5'), with each one having two surfaces and edges (6, 7), of which components at least one is worked out of the sheet-like material coated with said adhesive, whereby, while working the material, also removing part of said adhesive the material is coated with, thereby automatically conforming the remaining adhesive on the coated material to the shape of the component;
- working a storage space (10, 10') into at least one of the components (5, 5'); whereby, in order to form said case (12, 14) with said storage space (10, 10') in it, the components are attachable to one another on their surfaces with help of said remaining adhesive (2).

2. A method according to claim 1, **characterised in**
- coating at least a part of the sheet-like material (1) on at least one of its surfaces with double-sided tape (2);
- working at least one component out of the sheet-like material coated with double-sided tape (2), whereby, while working the material, the tape the component is coated with is also cut;
whereby, in order to form the case (12, 14) with the storage space (10, 10') in it, the components are attachable to one another on their surfaces with help of said tape (2).

3. A method according to claim 1 or 2, **characterised in**
- working a storage space (10) into at least one component (5, 5') by removing material from a part of the sheet-like component for its entire depth.

4. A method according to any previous claim, **characterised in**
- working a storage space into at least one component by forming a recess in the surface of the component, which recess does not pierce the sheet-like component.

5. A method according to any previous claim, **characterised in**
- working a storage space (10, 10') into at least one of the components (5, 5') by removing both adhesive and sheet-like material.

6. Method for manufacturing a case (12, 14), **characterised in that** the case is manufactured out of components (4, 5, 5') for a case manufactured according to any of claims 1-4, whereby the method additionally comprises at least the following steps
- attaching said at least two sheet-like components (4, 5, 5') to one another, whereby the components are attached to one another using said adhesive (2), so that a case (12, 14) with the said storage space in it is formed.

7. A method according to claim 6, **characterised in**
- forming the case (12, 14) by attaching at least three components on top of each other, of which one or more middle components (5, 5') have a storage space (10) worked into them by removing material from the entire depth of the component.

8. A method according to claim 7, **characterised in that**
- there are two or more middle components (5, 5') which are mainly of same shape with regard to each other, attached to each other and aligned with each other.

9. Manufacturing set for a case, **characterised in that** it comprises at least two sheet-like components (4, 5, 5'), which are manufactured according to any of the claims 1 through 8.

10. A manufacturing set according to claim 9, **characterised in that** it comprises at least three sheet-like components (4, 5, 5') each one having two surfaces and edges (6, 10 7), whereby - a storage space (10) has been worked into at least one component (5, 5') meant to be a middle component in the case, by removing material from the entire depth of the component.

11. A manufacturing set according to claim 9 or 10, **characterised in that** the adhesive is double-sided tape (2).

12. A manufacturing set according to any previous claim 9-11, **characterised in that** the surface of the component is coated with an adhesive (2) only partially.

13. A manufacturing set according to any previous claim 9-12, **characterised in that** there are two or more components (5, 5') that are meant to be middle components in the case, and that they are mainly of same shape with regard to each other and intended to be attached to each other and aligned with each other.

14. A device (20), **characterised in** comprising a manufacturing set according to any of the claims 9 through 13, which set has been assembled according to the method of claim 6 as a case (12, 14), and at least one electrical component (16, 17, 18, 19) placed in said storage space (10, 10') of the case.

15. A device (20) according to claim 14, **characterised in** comprising an accelerometer (18), a radio transmitter and a microcontroller (17) functionally connected with one another and placed in the storage space.

## Patentansprüche

1. Verfahren zur Herstellung von Bauteilen eines Gehäuses (12, 14), das Gehäuse umfassend mindestens zwei Bauteilen aus blattförmigem Material, wobei die Bauteilen gemeinsam einen Lagerraum bilden, wobei das Verfahren zumindest die folgenden Schritte umfasst:
- zuerst, Beschichten mindestens eines Teils eines blattförmigen Materials (1) auf mindestens einer seiner Flächen mit einem Klebstoff (2);
- anschliessend, Bearbeiten das blattförmige Material (1) in mindestens zwei blattförmige Bauteile (4, 5, 5'), die beide Bauteile mit zwei Flächen und Kanten (6, 7), wobei mindestens ein aus den Bauteilen von dem mit Klebstoff beschichteten blattförmigen Material bearbeitet ist, wobei bei der Bearbeitung des Materials auch ein Teil des Klebstoffs, mit dem das Material beschichtet ist, entfernt wird, wodurch der verbleibende Klebstoff auf dem beschichteten Material automatisch an die Form des Bauteils angepasst wird;
- Bearbeiten eines Lagerraums (10, 10') in mindestens eines der Bauteile (5, 5'); wobei um ein Gehäuse (12, 14) mit einem Lagerraum (10, 10') darin zu bilden, die Bauteilen an ihren Flächen mit Hilfe des verbleibende Klebstoffs (2) aneinander befestigbar sind.

2. Verfahren nach Anspruch 1, **gekennzeichnet,** bei
- Beschichten mindestens eines Teils des blattförmigen Materials (1) auf mindestens einer seiner Flächen mit doppelseitigem Klebeband (2);
- Bearbeiten mindestens eines Bauteils aus dem mit doppelseitigem Klebeband (2) beschichteten blattförmigen Material, wobei bei der Bearbeitung des Materials auch das Klebeband, mit dem das Bauteil beschichtet ist, geschnitten wird;
wobei um das Gehäuse (12, 14) mit dem Lagerraum (10, 10') darin zu bilden, die Bauteilen an ihren Flächen mit Hilfe des Klebebandes (2) aneinander befestigbar sind.

3. Verfahren nach Anspruch 1 oder 2, **gekennzeichnet,** bei
- Bearbeiten eines Lagerraums (10) in mindestens ein Bauteil (5, 5') durch Entfernen von Material von einem Teil desblattförmigen Bauteils über dessen gesamte Tiefe.

4. Verfahren nach einem der vorhergehenden Ansprüche, **gekennzeichnet,** bei
- Bearbeiten eines Lagerraums in mindestens ein Bauteil durch Ausbildung einer Vertiefung in der Fläche des Bauteils, welche Vertiefung das blattförmige Bauteil nicht durchdringt.

5. Verfahren nach einem der vorhergehenden Ansprüche, **gekennzeichnet,** bei
- Bearbeiten eines Lagerraums (10, 10') in mindestens eines der Bauteile (5, 5') durch Entfernen sowohl den Klebstoff als auch das blattförmige Material.

6. Verfahren zur Herstellung eines Gehäuses (12, 14), **dadurch gekennzeichnet, dass** das Gehäuse aus Bauteilen (4, 5, 5') für ein Gehäuse hergestellt ist, das nach einem der Ansprüche 1 bis 4 hergestellt ist, wobei das Verfahren zusätzlich mindestens die folgenden Schritte umfasst:
- Befestigen der mindestens zwei blattförmigen Bauteile (4, 5;5') aneinander, wobei die Bauteile mit dem Klebstoff (2) aneinander befestigt sind, so dass ein Gehäuse (12, 14) mit dem genannten Lagerraum darin gebildet ist.

7. Verfahren nach Anspruch 6, **gekennzeichnet,** bei
- Bilden des Gehäuses (12, 14) durch Befestigen von mindestens drei Bauteile übereinander, von denen ein oder mehrere mittlere Bauteile (5, 5') einen in sie gebildeten Lagerraum (10) durch Entfernen von Material über der gesamte Tiefe des Bauteils aufweisen.

8. Verfahren nach Anspruch 7, **dadurch gekennzeichnet, dass**
- es gibt zwei oder mehr mittlere Bauteile (5, 5'), die im Wesentlichen die gleiche Form zueinander aufweisen, aneinander befestigt und miteinander ausgerichtet sind.

9. Herstellungsset für ein Gehäuse, **dadurch gekennzeichnet, dass** es mindestens zwei blattförmige Bauteile (4, 5, 5') umfasst, die nach einem der Ansprüche 1 bis 8 hergestellt sind.

10. Herstellungsset nach Anspruch 9, **dadurch gekennzeichnet, dass** er mindestens drei blattförmige Bauteile (4, 5, 5') mit jeweils zwei Flächen und Kanten (6, 7) umfasst, wobei
- in mindestens einem als Mittelteil des Gehäuses vorgesehenen Bauteil (5, 5') ein Lagerraum (10) gebildet ist, indem Material aus der gesamten Tiefe des Bauteils entfernt wird.

11. Herstellungsset nach Anspruch 9 oder 10, **dadurch gekennzeichnet, dass** der Klebstoff doppelseitiges Klebeband (2) ist.

12. Herstellungsset nach einem der vorhergehenden Ansprüche 9 bis 11, **dadurch gekennzeichnet, dass** Die Fläche des Bauteils nur teilweise mit einem Klebstoff (2) beschichtet ist.

13. Ein Herstellungsset nach einem der vorhergehenden Ansprüche 9 bis 12, **dadurch gekennzeichnet, dass** es zwei oder mehr Komponenten (5, 5') gibt, die als mittlere Bauteile in dem Gehäuse gedacht sind, , und dass sie im Wesentlichen die gleiche Form zueinander aufweisen und aneinander befestigt und miteinander ausgerichtet sind.

14. Eine Vorrichtung (20), **dadurch gekennzeichnet, dass** sie einen Herstellungssatz nach einem der Ansprüche 9 bis 13 umfasst, der nach dem Verfahren nach Anspruch 6 als Gehäuse (12, 14) zusammengebaut wurde, und mindestens ein elektrisches Bauteil (16, 17, 18, 19), das in dem Lagerraum (10, 10') des Gehäuses angeordnet ist.

15. Vorrichtung (20) nach Anspruch 14, **dadurch gekennzeichnet, dass** sie einen Beschleunigungsmesser (18), einen Funksender und einen Mikrocontroller (17) umfasst, die funktionell miteinander verbunden und im Lagerraum angeordnet sind.

## Revendications

1. Procédé de fabrication de composants d'un boîtier (12, 14), ledit boîtier comprenant au moins deux composants en matériau de type feuille, les composants formant conjointement un espace de stockage, le procédé comprenant au moins les étapes suivantes:
- premièrement, on revêt au moins une partie d'un matériau de type feuille (1) sur au moins une de ses surfaces avec un adhésif (2);
- ensuite, on travaille ledit matériau de type feuille (1) en au moins deux composants de type feuille (4, 5, 5') avec chacun ayant deux surfaces et bords (6, 7), au moins un desquels composants est travaillé à partir du matériau de type feuille revêtu avec ledit adhésif, moyennant quoi, tout en travaillant le matériau, on enlève aussi une partie dudit adhésif avec lequel le matériau est revêtu, ainsi conformant automatiquement l'adhésif restant sur le matériau revêtu à la forme du composant;
- on travaille un espace de stockage (10, 10') dans au moins l'un des composants (5, 5'); moyennant quoi, afin de former ledit boîtier (12, 14) avec ledit espace de stockage (10, 10') dans celui-ci, les composants peuvent être fixés l'un à l'autre sur leurs surfaces à l'aide dudit adhésif restant (2).

2. Un procédé selon la revendication 1, **caractérisé en ce que**
- l'on revêt au moins une partie du matériau de type feuille (1) sur au moins une de ses surfaces avec une bande double face (2);
- l'on travaille au moins un composant à partir du matériau de type feuille revêtu avec une bande double face (2), moyennant quoi, tout en travaillant le matériau, la bande avec laquelle le composant est revêtu est également coupée;
moyennant quoi, afin de former le boîtier (12, 14) avec l'espace de stockage (10, 10') dans celui-ci, les composants peuvent être fixés l'un à l'autre sur leurs surfaces à l'aide de ladite bande (2).

3. Un procédé selon la revendication 1 ou 2, **caractérisé en ce que**
- l'on travaille un espace de stockage (10) dans au moins un composant (5, 5') en enlevant du matériau d'une partie du composant de type feuille dans toute sa profondeur.

4. Un procédé selon l'une quelconque des revendications précédentes, **caractérisé en ce que**
- l'on travaille un espace de stockage dans au moins un composant en formant un évidement dans la surface du composant, lequel évidement ne perce pas le composant de type feuille.

5. Un procédé selon l'une quelconque des revendications précédentes, **caractérisé en ce que**
- l'on travaille un espace de stockage (10, 10') dans au moins l'un des composants (5, 5') en enlevant aussi bien de l'adhésif que du matériau de type feuille.

6. Procédé de fabrication d'un boîtier (12, 14), **caractérisé en ce que** le boîtier est fabriqué à partir de composants (4, 5, 5') pour un boîtier fabriqué selon l'une quelconque des revendications 1 à 4, moyennant quoi le procédé comprend en outre au moins les étapes suivantes:
- on fixe lesdits au moins deux composants de type feuille (4, 5, 5') l'un à l'autre, moyennant quoi les composants sont fixés l'un à l'autre en utilisant ledit adhésif (2), de telle sorte qu'un boîtier (12, 14) avec ledit espace de stockage dans celui-ci est formé.

7. Un procédé selon la revendication 6, **caractérisé en ce que**
- l'on forme le boîtier (12, 14) en fixant au moins trois composants l'un au-dessus de l'autre, dont un ou plus composants intermédiaires (5, 5') ont un espace de stockage (10) travaillé dans ceux-ci en enlevant du matériau de toute la profondeur du composant.

8. Un procédé selon la revendication 7, **caractérisé en ce qu'**
- il y a deux ou plus composants intermédiaires (5, 5') qui sont principalement de même forme l'un par rapport à l'autre, fixés l'un à l'autre et alignés l'un avec l'autre.

9. Ensemble de fabrication pour un boîtier, **caractérisé en ce qu'**il comprend au moins deux composants de type feuille (4, 5, 5'), qui sont fabriqués selon l'une quelconque des revendications 1 à 8.

10. Un ensemble de fabrication selon la revendication 9, **caractérisé en ce qu'**il comprend au moins trois composants de type feuille (4, 5, 5') ayant chacun deux surfaces et bords (6, 7), moyennant quoi
- un espace de stockage (10) a été travaillé dans au moins un composant (5, 5') destiné à être un composant intermédiaire dans le boîtier, en enlevant du matériau de toute la profondeur du composant.

11. Un ensemble de fabrication selon la revendication 9 ou 10, **caractérisé en ce que** l'adhésif est une bande double face (2).

12. Un ensemble de fabrication selon l'une quelconque des revendications précédentes 9 à 11, **caractérisé en ce que** la surface du composant est revêtue avec un adhésif (2) seulement partiellement.

13. Un ensemble de fabrication selon l'une quelconque des revendications précédentes 9 à 12, **caractérisé en ce qu'**il y a deux ou plus composants (5, 5') qui sont destinés à être des composants intermédiaires dans le boîtier, et qu'ils sont principalement de même forme l'un par rapport à l'autre et destinés à être fixés l'un à l'autre et alignés l'un avec l'autre.

14. Un dispositif (20), **caractérisé en ce qu'**il comprend un ensemble de fabrication selon l'une quelconque des revendications 9 à 13, lequel ensemble a été assemblé selon le procédé de la revendication 6 en tant que boîtier (12, 14), et au moins un composant électrique (16, 17, 18, 19) placé dans ledit espace de stockage (10, 10') du boîtier.

15. Un dispositif (20) selon la revendication 14, **caractérisé en ce qu'**il comprend un accéléromètre (18), un émetteur radio et un microcontrôleur (17) reliés fonctionnellement l'un à l'autre et placés dans l'espace de stockage.
